# EUROPÄISCHE PATENTSCHRIFT

(11) **EP 3 915 345 B1**
(45) Veröffentlichungstag und Bekanntmachung des Hinweises auf die Patenterteilung: **29.11.2023**
(21) Anmeldenummer: 20711823.3
(22) Anmeldetag: 06.03.2020
(51) Int. Cl.: H05K 5/02

(54) **SENDERGEHÄUSE**
TRANSMITTER HOUSING
BOÎTIER D'ÉMETTEUR

(30) Priorität: 05.04.2019 DE 202019101984 U
(43) Veröffentlichungstag der Anmeldung: 01.12.2021
(73) Patentinhaber: Haug, Thomas, 75217 Birkenfeld (DE)
(72) Erfinder: Haug, Thomas, 75217 Birkenfeld (DE)
(74) Vertreter: Wacker, Jost Oliver
(86) Internationale Anmeldenummer: PCT/EP2020/055962
(87) Internationale Veröffentlichungsnummer: WO 2020/200643

(56) Entgegenhaltungen:
- JP-A- 2008 112 905
- US-A1- 2010 110 620
- US-A1- 2017 073 198
- "Enrange MLTX2 Bellybox Transmitter", Canada, 16. März 2012 (2012-03-16), Seiten 1-2, XP055186202, www.magnetekhydraulic.com Gefunden im Internet: URL:http://www.proportionalradiocontrols.c om/pdf/MLTX-Belly-Box-Radio-Brochure.pdf [gefunden am 2015-04-28]
- Control Chief Wireless Solutions: "L Series Industrial Wireless Radio Remote Control System", , 9. Mai 2010 (2010-05-09), Seiten 1-2, XP055385417, Internet; controlchief.com Gefunden im Internet: URL:https://www.controlchief.com/ [gefunden am 2017-06-27]

## Beschreibung

Die Erfindung betrifft ein Sendergehäuse eines Bediengerätes für Geräte und Anlagen, wie insbesondere ferngesteuerte mobile, industrielle oder gewerbliche Geräte und Anlagen, nach dem Oberbegriff des Anspruchs 1. Das Sendergehäuse weist eine Gehäusewandung auf, die eine Aufnahme umschließt, wobei an einer Außenseite der Gehäusewandung wenigstens ein Bedienelement, wie ein Steuerungsknüppel beziehungsweise Joystick, ein Schalter oder Regler und/oder ein berührungsempfindliches Display angebracht ist. In der von der Gehäusewandung umschlossenen Aufnahme ist zudem eine Steuerungselektronik aufgenommen. Ferner sind zwei Halteelemente vorgesehen, von denen ein erstes Halteelement mit einem linksseitigen Ende und ein zweites Halteelement mit einem rechtsseitigen Ende der Gehäusewandung verbunden ist. Auf diese Weise verschließen die Halteelemente die von der Gehäusewandung umschlossene Aufnahme. Die Halteelemente ragen dabei zu allen Seiten, das heißt in einer ober-, unter-, vor-, rück-, links- und rechtsseitigen Richtung über die Kontur der Gehäusewandung hinaus.

Aus der WO2008/055480A1 ist ein Bediengerät für Fernsteuerungen bekannt, bei dem die Gehäusewandung aus zwei abgelängten Profilelementen zusammengesetzt ist. An beiden Enden der so gebildeten Gehäusewandung ist dabei jeweils ein X-förmiges Halteelement angebracht, das aus einem Kunststoffformteil besteht. Die durch die X-Form gebildeten unteren Arme der Halteelemente dienen dabei als Standfüße während zwischen den oberen Haltearmen Stangen gehalten sind, die als zusätzliche Handauflage und/oder als Schutz für die Bedienelemente dienen.

JP2008112905A zeigt ferner einen Protektor für eine tragbare elektronische Vorrichtung. Dieser weist eine mit einem Gummiteil verbundene Metallplatte auf, die an der Außenseite eines geschlossenen Gehäuses der elektronischen Vorrichtung festgeschraubt werden kann. Die Metallplatte wird hierbei an mehrere Stellen von Klauenelementen des Gummiteils umgriffen, um beiden Teile aneinander festzulegen. Zudem können die Klauenelemente an entsprechend geformten Aufnahmen des Gehäuses angebracht werden, um den Protektor leichter an dem Gehäuse festschrauben zu können.

Die Aufgabe der Erfindung ist es, bei einem gattungsgemäßen Sendergehäuse bei einfacher Herstellung den Schutz der für den Betrieb des Bediengerätes benötigten Bauteile zu erhöhen sowie den Bedienkomfort weiter zu verbessern.

Diese Aufgabe wird durch ein Sendergehäuse mit den Merkmalen des Anspruchs 1 gelöst. Dabei sind die Halteelemente wenigstens im jeweiligen Kontaktbereich mit der Gehäusewandung aus einem Elastomermaterial, wie beispielsweise Gummi gebildet und selbst gegen die Gehäusewandung abdichtend vorspannbar. Hierdurch kann bereits durch die Verbindung der Halteelemente mit der Gehäusewandung eine gewisse Abdichtung der Aufnahme erzielt werden. Je nach vorgesehener Verwendungsart des Bediengerätes kann somit durch Auswahl eines geeigneten Elastomermaterials und durch Erzeugung einer ausreichenden Vorspannung im betreffenden Kontaktbereich, wie beispielsweise mittels einer Schraubverbindung, auch ohne zusätzliche Dichtungsmittel eine ausreichende Abdichtung der Aufnahme nach außen hin erzielt werden, wodurch die Herstellungskosten und der Montageaufwand reduziert werden kann. Im Falle besonders hoher Anforderungen an die Dichtigkeit können alternativ hierzu im jeweiligen Kontaktbereich zwischen den beiden Halteelementen und der Gehäusewandung auch noch zusätzliche Dichtungsmittel vorgesehen sein.

Dabei ist es günstig, wenn zusätzlich eine jeweils umlaufende Außenkontur der Halteelemente aus dem Elastomermaterial hergestellt ist. Hierdurch weisen die beiden Halteelemente eine umlaufend stoßdämpfende beziehungsweise energieabsorbierende Verformbarkeit auf, mittels der die Gehäusewandung beziehungsweise daran gehaltene Bedienelemente und elektronische Bauteile in alle Richtungen wirksam gegen Stöße geschützt werden können, wie insbesondere beim Herabfallen des Bediengerätes.

In einer besonders vorteilhaften Ausführungsform weisen beide Halteelemente einen vollständig aus dem Elastomermaterial hergestellten Grundkörper auf. Hierdurch können die Halteelemente auch mit relativ komplexen oder filigranen Funktions- oder Gestaltungsformteilen einfach hergestellt werden. Zudem kann ein Halteelement mit einem derartigen Grundkörper aus Elastomermaterial einen besonders hohen Schutz der an der Gehäusewandung und/oder den Halteelementen selbst aufgenommenen Bauteilen, wie insbesondere elektronischen oder elektrischen Bauteilen gewährleisten.

Dabei ist es günstig, wenn die Halteelemente jeweils zwei unterhalb der Gehäusewandung aus dem Elastomermaterial hergestellte bodenseitige Eckbereiche ausbilden, die sich auch vorder- und rückseitig über die Erstreckung der Gehäusewandung hinaus ersttrecken. Hierdurch ist das Bediengerät besonders stoß- und rutschfest abstellbar, wobei die sich über die Gehäusewandung heraus erstreckenden bodenseitigen Eckbereiche, insbesondere bei einem ruckartigen Abstellen oder Herunterfallen Stöße vermeiden können, die direkt auf die Gehäusewandung einwirken.

Vorteilhafterweise weisen die Halteelemente zudem jeweils zwei oberhalb der Gehäusewandung aus dem Elastomermaterial hergestellte oberseitige Eckbereiche auf, die sich auch vorder- und rückseitig über die Erstreckung der Gehäusewandung hinaus erstrecken. Durch die sich über die Gehäusewandung hinaus erstreckenden oberseitigen Eckbereiche können direkt von oben auf die Gehäusewandung einwirkende Stöße, wie im Betrieb oder durch Fallenlassen des Bediengerätes aufgenommen werden.

Zudem ist es besonders günstig, wenn die Halteelemente an den bodenseitigen Eckbereichen und/oder an oberseitigen Eckbereichen wenigstens eine innere Eckkontur ausformen, die unter Ausbildung eines freien Zwischenraumes von einem reversiblen Stoßfängerbügel nach außen hin abgeschirmt ist. Der Stoßfängerbügel bildet hierbei ein relativ stark verformbares Element, das dadurch eine besonders hohe stoßdämpfende beziehungsweise energieabsorbierende Wirkung aufweist. Der betreffende Eckbereich kann die Gehäusewandung und die an ihr aufgenommenen Bauteile dadurch auch gegenüber relativ starken Stoßeinwirkungen schützen.

Vorteilhafterweise formen dabei beide Halteelemente die vom reversiblen Stoßfängerbügel nach außen hin abgeschirmte innere Eckkontur jeweils an allen vier Eckbereichen unter Ausbildung des freien Zwischenraumes aus. Auf diese Weise können die Gehäusewandung und die an ihr aufgenommenen Bauteile zu allen Seiten gegen relativ starke Stoßeinwirkungen geschützt werden, wodurch das Bediengerät auch bei großen Fallhöhen eine ausreichende Stabilität beziehungsweise Energie absorbierende Eigenschaft aufweist.

Ferner ist es günstig, wenn der Stoßfängerbügel am jeweiligen freien Zwischenraum bogenförmig ausgebildet ist. Durch die Bogenform können die Stoßfängerbügel dabei zum einen relativ hohe Stützkräfte gegenüber von außen einwirkenden Kraftbeanspruchungen erzeugen. Zum anderen ermöglicht die Bogenform durch die relativ große verformbare Länge der Stoßfängerbügel bereits konstruktiv bedingt eine bessere Absorption von einwirkender Energie.

In einer weiteren vorteilhaften Ausführungsform erstreckt sich der Stoßfängerbügel und der zugehörige freie Zwischenraum jeweils von einer Seite zu wenigstens einer weiteren Seite des Halteelementes, vorzugsweise über einen Winkelbereich von wenigstens 90°. Auf diese Weise können die Gehäusewandung und die daran gehaltenen Bauteile durch nur einen einzelnen Stoßfängerbügel in wenigstens zwei Richtungen abgeschirmt werden.

Ferner ist es günstig, wenn sich wenigstens einer der Stoßfängerbügel zusammen mit dem zugehörigen freien Zwischenraum von einer ersten Seite über eine gesamte zweite Seite zu einer dritten Seite des Halteelementes erstreckt. Auf diese Weise können die Gehäusewandung und die daran gehaltenen Bauteile durch nur einen einzelnen Stoßfängerbügel in wenigstens drei Richtungen abgeschirmt werden.

Vorteilhafterweise ist dabei an der zweiten Seite eine Griffmulde im zugehörigen freien Zwischenraum ausgebildet. Hierdurch kann das Bediengerät besonders komfortabel gehalten werden, wobei auch die haltende Hand des Benutzers durch den Stoßfängerbügel abgeschirmt und somit gegenüber Stoßeinwirkungen von außen geschützt ist.

Zudem ist es günstig, wenn an einer Seite der Halteelemente zwischen zwei der Stoßfängerbügeln ein zusätzlicher Schutzbügel ausgebildet ist, an dem eine Zusatzgriffmulde ausgeformt ist, um dem Benutzer eine zusätzliche geschützte Greifposition zur Verfügung stellen zu können.

Ferner ist in wenigstens einem der Stoßfängerbügel vorteilhafterweise eine Antenne aufgenommen. Eine derartige Aufnahme der Antenne im Stoßfängerbügel ermöglicht dabei eine relativ große Erstreckung der Antenne sowie, insbesondere bei Herstellung des Stoßfängerbügels aus Gummi, eine ungestörte Sende- und/oder Empfangsleistung.

Zudem ist es günstig, wenn in wenigstens eines der Halteelemente eine Zusatzaufnahme eingelassen ist, die über eine Stirnseite des Halteelements zugänglich ist. Die Zusatzaufnahme kann dabei zur Aufnahme hin entweder mit einer Durchtrittsöffnung ausgebildet sein, um durch diese hindurch auch auf die Aufnahme der Gehäusewandung zugreifen zu können. Alternativ kann die Zusatzaufnahme auch derart in die Stirnseite des Halteelementes eingelassen sein, dass sie zur Aufnahme hin einen geschlossenen Boden ausbildet. Eine derartige Zusatzaufnahme bietet in jedem Fall trotz komfortabler und einfacher Zugriffsmöglichkeit einen besonders hohen Schutz von aufgenommenen Bauteilen gegenüber äußeren Einwirkungen. Dadurch können an beiden Halteelementen zusätzliche elektrische oder elektronische Bauteile, wie beispielsweise Schalt- oder Sensorikelemente oder ein Akkuschacht geschützt aufgenommen werden.

Vorteilhafterweise ist dabei ein Akkuschacht in die wenigstens eine Zusatzaufnahme eingesetzt. Auf diese Weise können die für die Energieversorgung des Bediengerätes benötigten Batterien beziehungsweise Akkus besonders gut geschützt aufgenommen werden, wobei die in das Halteelement eingelassene Zusatzaufnahme eine sichere Abdichtung nach außen ermöglicht. Zudem sind die Batterien beziehungsweise Akkus auf diese Weise besonders einfach zugänglich, wie insbesondere zum Aufladen oder Austauschen.

Ferner ist es günstig, wenn ein Lagerelement in die Zusatzaufnahme einsetzbar ist, das unter Zwischenlage des Halteelements an der Gehäusewandung vorspannbar ist, die vorzugsweise aus Metall hergestellt ist. Auf diese Weise ist eine stabile und abdichtende Festlegung des betreffenden Halteelements an der Gehäusewandung möglich.

Es wird darauf hingewiesen, dass alle oben beschriebenen Merkmale des erfindungsgemäßen Gegenstandes untereinander austauschbar beziehungsweise kombinierbar sind, sofern ein Austausch oder eine Kombination derselben aus technischen Gründen nicht ausgeschlossen ist.

In den Figuren ist eine beispielhafte Ausführungsform der Erfindung dargestellt. Es zeigen:
- Figur 1: eine Draufsicht auf ein Bediengerät mit einem erfindungsgemäßen Sendergehäuse,
- Figur 2: eine geschnittene Ansicht des Sendergehäuses in Ebene II-II aus Fig. 1,
- Figur 3: eine Ansicht des Sendergehäuses in Richtung III aus Fig 1 und
- Figur 4: eine explodierte Ansicht einer Zusatzaufnahme des Sendergehäuses.

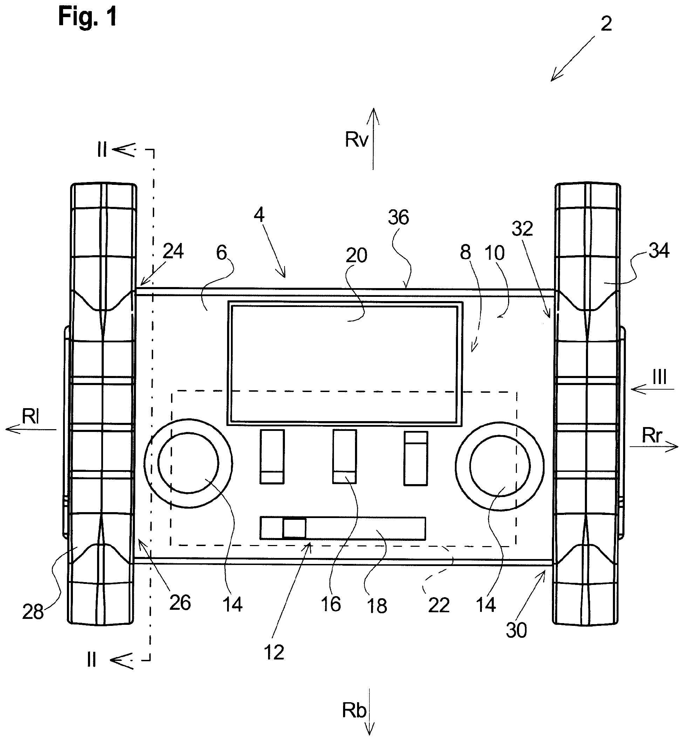

Fig. 1 zeigt ein Bediengerät 2 in Form einer Fernsteuerung für Geräte und Anlagen, wie insbesondere ferngesteuerte mobile, industrielle oder gewerbliche Hub- oder Transportanlagen. Das Bediengerät 2 weist dabei ein Sendergehäuse 4 mit einer Gehäusewandung 6 auf, die eine Aufnahme 8 umschließt. An einer Außenseite 10 der Gehäusewandung 6 lagern verschiedene Bedienelemente 12, die beispielhaft als Joysticks 14, Schalter 16, Regler 18 und berührungsempfindlicher Bildschirm 20 dargestellt sind. Diese sind zum Betrieb des Bediengerätes 2 mit einer Steuerungselektronik 22 verbunden, die geschützt in der Aufnahme 8 aufgenommen ist.

Wie aus Fig. 1 ferner zu entnehmen ist, ist die Gehäusewandung 6 an einem linksseitigen Ende 24 über einen ersten Kontaktbereich 26 mit einem ersten Halteelement 28 und an einem rechtsseitigen Ende 30 über einen zweiten Kontaktbereich 32 mit einem zweiten Halteelement 34 verbunden. Die beiden Halteelemente 26, 30 sind dabei derart angeordnet, dass sie in linksseitiger Richtung Rl, rechtsseitiger Richtung Rr, vorderseitiger Richtung Rv und rückseitiger Richtung Rb über eine Kontur 36 der Gehäusewandung 6 hinausragen.

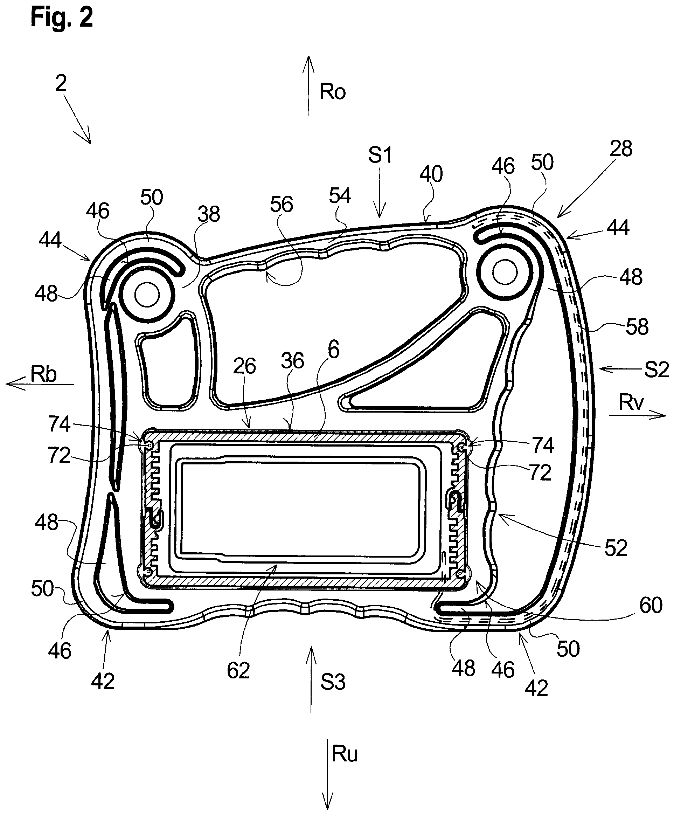

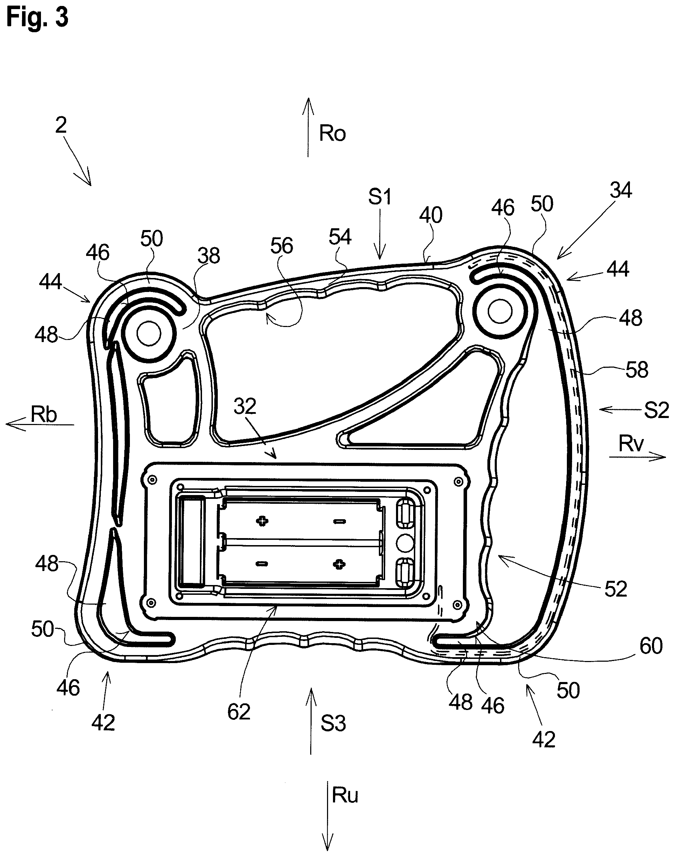

Wie ferner an den in den Figuren 2 und 3 dargestellten Halteelementen 28, 34 zu entnehmen ist, ragen diese zudem auch in einer oberseitigen Richtung Ro und einer bodenseitigen Richtung Ru über die Kontur 36 der Gehäusewandung 6 hinaus. Dabei weisen die Halteelemente 28, 34 einen Grundkörper 38, der sowohl den jeweiligen Kontaktbereich 26, 32 als auch eine umlaufende Außenkontur 40 der Halteelemente 28, 34 bildet und der vollständig aus einem Elastomermaterial, wie insbesondere Gummi hergestellt ist. Das erste Halteelement 28 und das entsprechend ausgebildete zweite Halteelement 34 können somit durch ihre Materialeigenschaften und ihre Anordnung gegenüber der Gehäusewandung 6 als stoßdämpfende Elemente des Bediengerätes 2 fungieren, die gegenüber von außen einwirkenden Kräften energieabsorbierend wirken.

Wie aus den Figuren 2 und 3 ferner zu entnehmen ist, bilden die Grundkörper 38 in den in vorderseitiger Richtung Rv und den in rückseitiger Richtung Rr über die Gehäusewandung 6 hinausstehenden Bereichen unterhalb der Gehäusewandung 6 jeweils zwei bodenseitige Eckbereiche 42 aus. Über diese ist das Bediengerät 2 rutschfest abstellbar. Ferner bilden die Grundkörper 38 in den in vorderseitiger Richtung Rv und den in rückseitiger Richtung Rr über die Gehäusewandung 6 hinausstehenden Bereichen oberhalb der Gehäusewandung 6 jeweils zwei oberseitige Eckbereiche 44.

An allen Eckbereichen 42, 44 ist dabei eine innere Eckkontur 46 vorgesehen, die unter Ausbildung eines freien Zwischenraumes 48 nach außen hin von einem reversiblen Stoßfängerbügel 50 abgeschirmt ist. Die Stoßfängerbügel 50 erstrecken sich dabei jeweils bogenförmig über einen Winkelabschnitt von wenigstens 90° von einer Seite zu einer anderen Seite des jeweiligen Halteelementes 28, 34. Vorderseitig erstreckt sich der Stoßfängerbügel 50 darüber hinaus von einer Oberseite S1, über die gesamte Vorderseite S2 bis zu einer Bodenseite S3 des jeweiligen Halteelementes 28, 34. An der Vorderseite S2 ist dabei unterhalb des Stoßfängerbügels 50 zudem eine Griffmulde 52 ausgeformt. Zudem ist an der Oberseite S1 zwischen zwei der Stoßfängerbügel 50 zusätzlich ein Schutzbügel 54 ausgebildet, der sich über eine Zusatzgriffmulde 56 erstreckt.

Wie aus den Figuren 2 und 3 ferner zu entnehmen ist, dient der vorderseitige Stoßfängerbügel 50 jeweils zur geschützten Aufnahme einer Antenne 58, wobei das amorphe Gummimaterial des Stoßfängerbügels 50 hierbei eine ungestörte Sende- und Empfangsfunktion ermöglicht.

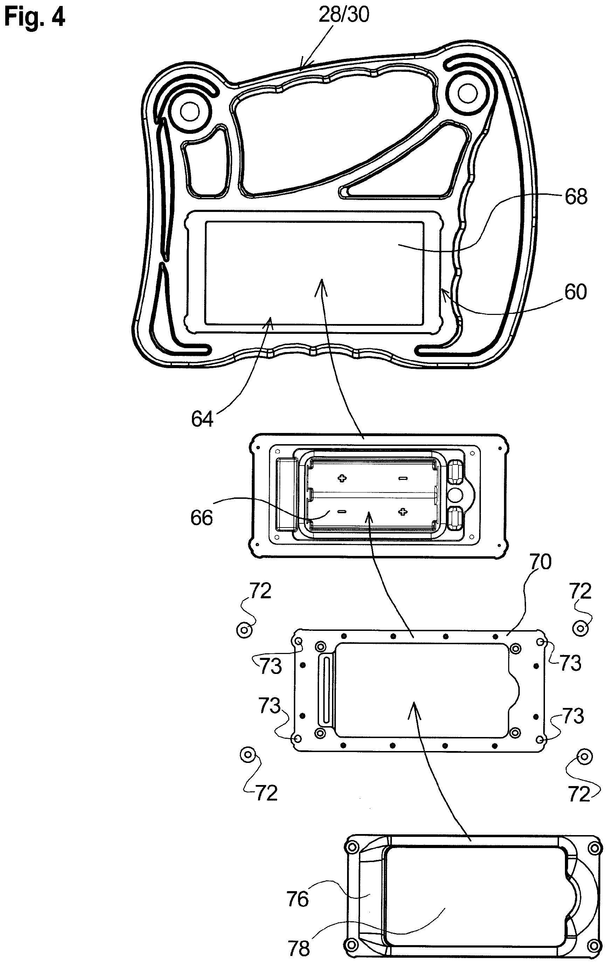

In einer Stirnseite 60 beider Halteelemente 28, 34 ist zudem jeweils eine Zusatzaufnahme 62 vorgesehen. Wie insbesondere aus Figur 4 zu entnehmen ist, besteht diese beispielhaft aus einer in die Stirnseite 60 eingelassenen Materialausnehmung 64, in die ein Akkuschacht 66 eingesetzt werden kann. Alternativ oder zusätzlich hierzu können an an den Zusatzaufnahmen 62 auch sonstige zusätzliche elektrische oder elektronische Bauteile geschützt aufgenommen werden, wie beispielsweise Schalt- oder Sensorikelemente (nicht dargestellt). Die Materialausnehmung 64 kann dabei entweder, wie dargestellt, mit einer Durchtrittsöffnung 68 ausgebildet sein, so dass bei entnommenem Akkuschacht 66 ein Zugriff auf die Aufnahme 8 frei gegeben ist. Alternativ hierzu kann die Materialausnehmung 64 mit einem geschlossenen Boden ausgebildet sein (nicht dargestellt), um eine besonders sichere Abdichtung sowohl des Akkuschachtes 66 als auch der Aufnahme 8 nach außen hin zu ermöglichen.

Ferner ist ein Lagerelement 70, wie insbesondere eine Metallplatte vorgesehen, die, wie dargestellt, separat ausgebildet ist oder alternativ hierzu auch in den Akkuschacht 66 integriert sein kann. Diese dient zur Aufnahme von Schrauben 72, die durch entsprechende Bohrungen 73 hindurch unter Zwischenlage des betreffenden Halteelementes 28; 34 in Schraubenaufnahmen 74 der Gehäusewandung 6 eingedreht werden können (siehe Figur 2), um das jeweilige Halteelement 28; 34 an der Gehäusewandung 6 festzuspannen. Durch das Elastomermaterial in den Kontaktbereichen 26, 32 können die Halteelemente 28, 34 hierbei selbst abdichtend gegen die Gehäusewandung 6 vorgespannt werden. Zur Erhöhung der Dichtigkeit können bei Bedarf zudem zusätzliche Dichtungsmittel in den Kontaktbereichen 26, 32 vorgesehen sein (nicht dargestellt).

Zum Verschließen des Akkuschachtes 66 dient ferner ein Rahmenteil 76, das gemeinsam mit dem Lagerelement 70 verschraubt wird und in das ein Deckel 78 eingesetzt werden kann.

Es wird darauf hingewiesen, dass alle oben beschriebenen Elemente und Merkmale der verschiedenen Ausführungsformen des erfindungsgemäßen Gegenstandes untereinander austauschbar beziehungsweise kombinierbar sind, sofern ein Austausch oder eine Kombination derselben aus technischen Gründen nicht ausgeschlossen ist.

## Patentansprüche

1. Sendergehäuse (4) eines Bediengerätes (2) für Geräte und Anlagen, wie insbesondere ferngesteuerte mobile, industrielle oder gewerbliche Geräte und Anlagen
mit einer Gehäusewandung (6), die eine Aufnahme (8) umschließt, wobei an einer Außenseite (10) der Gehäusewandung (6) wenigstens ein Bedienelement (12) angebracht und in der Aufnahme (8) eine Steuerungselektronik (22) aufgenommen ist,
und mit zwei die Aufnahme (8) verschließenden Halteelementen (28, 34), die mit einem linksseitigen Ende (24) und einem rechtsseitigen Ende (30) der Gehäusewandung (6) verbunden sind, und dabei zu allen Seiten (Rl, Rr, Rv, Rb, Ro, Ru) der Gehäusewandung (6) über deren Kontur (36) hinausragen,
**dadurch gekennzeichnet, dass** die Halteelemente (28, 34) wenigstens in einem jeweiligen Kontaktbereich (26, 32) mit der Gehäusewandung (6) aus einem Elastomermaterial hergestellt und gegen diese selbst abdichtend vorspannbar sind.

2. Sendergehäuse nach Anspruch 1, **dadurch gekennzeichnet, dass** zusätzlich eine jeweils umlaufende Außenkontur (40) der Halteelemente (28, 34) aus dem Elastomermaterial hergestellt ist.

3. Sendergehäuse nach Anspruch 1 oder 2, **dadurch gekennzeichnet, dass** beide Halteelemente (28, 34) einen vollständig aus dem Elastomermaterial hergestellten Grundkörper (38) aufweisen.

4. Sendergehäuse nach einem der Ansprüche 1 bis 3, **dadurch gekennzeichnet, dass** die Halteelemente (28, 34) jeweils zwei unterhalb der Gehäusewandung (6) aus dem Elastomermaterial hergestellte bodenseitige Eckbereiche (42) aufweisen, die sich auch vorder- und rückseitig über die Erstreckung der Gehäusewandung (6) hinaus ersttrecken.

5. Sendergehäuse nach einem der Ansprüche 1 bis 4, **dadurch gekennzeichnet, dass** die Halteelemente (28, 34) jeweils zwei oberhalb der Gehäusewandung (6) aus dem Elastomermaterial hergestellte oberseitige Eckbereiche (44) aufweisen, die sich auch vorder- und rückseitig über die Erstreckung der Gehäusewandung (6) hinaus erstrecken.

6. Sendergehäuse nach einem der 4 oder 5, **dadurch gekennzeichnet, dass** die Halteelemente (28, 34) an den bodenseitigen Eckbereichen (42) und/oder an oberseitigen Eckbereichen (44) wenigstens eine innere Eckkontur (46) ausformen, die unter Ausbildung eines freien Zwischenraumes (48) von einem reversiblen Stoßfängerbügel (50) nach außen hin abgeschirmt ist.

7. Sendergehäuse nach Anspruch 6, **dadurch gekennzeichnet, dass** beide Halteelemente (28, 34) die vom reversiblen Stoßfängerbügel (50) nach außen hin abgeschirmte innere Eckkontur (46) jeweils an allen vier Eckbereichen (42, 44) unter Ausbildung des freien Zwischenraumes (48) ausformen.

8. Sendergehäuse nach Anspruch 6 oder 7, **dadurch gekennzeichnet, dass** der Stoßfängerbügel (50) am jeweiligen freien Zwischenraum (48) bogenförmig ausgebildet ist.

9. Sendergehäuse nach einem der Ansprüche 6 bis 8, **dadurch gekennzeichnet, dass** sich der Stoßfängerbügel (50) und der zugehörige freie Zwischenraum (48) jeweils von einer Seite zu wenigstens einer weiteren Seite des Halteelementes erstrecken.

10. Sendergehäuse nach einem der Ansprüche 6 bis 9, **dadurch gekennzeichnet, dass** sich wenigstens einer der Stoßfängerbügel (50) zusammen mit dem zugehörigen freien Zwischenraum (48) von einer ersten Seite (S1) über eine gesamte zweite Seite (S2) zu einer dritten Seite (S3) des Halteelementes (28; 34) erstreckt.

11. Sendergehäuse nach Anspruch 10, **dadurch gekennzeichnet, dass** an der zweiten Seite (S2) eine Griffmulde (52) im zugehörigen freien Zwischenraum (48) ausgebildet ist.

12. Sendergehäuse nach einem der Ansprüche 6 bis 11, **dadurch gekennzeichnet, dass** an einer Seite der Halteelemente (28, 34) zwischen zwei der Stoßfängerbügeln (50) ein Schutzbügel (54) ausgebildet ist, an dem eine Zusatzgriffmulde (56) ausgeformt ist.

13. Sendergehäuse nach einem der Ansprüche 6 bis 12, **dadurch gekennzeichnet, dass** in wenigstens einem der Stoßfängerbügel (50) eine Antenne (58) aufgenommen ist.

14. Sendergehäuse nach einem der Ansprüche 6 bis 13, **dadurch gekennzeichnet, dass** in wenigstens eines der Halteelemente (28, 34) eine Zusatzaufnahme (62) eingelassen ist, die über eine Stirnseite (60) des Halteelements (28, 34) zugänglich ist.

15. Sendergehäuse nach Anspruch 14, **dadurch gekennzeichnet, dass** ein Akkuschacht (66) in die wenigstens eine Zusatzaufnahme (62) eingesetzt ist.

16. Sendergehäuse nach Anspruch 14 oder 15, **dadurch gekennzeichnet, dass** ein Lagerelement (70) in die Zusatzaufnahme (62) einsetzbar ist, das unter Zwischenlage des Halteelements (28; 34) an der Gehäusewandung (6) vorspannbar ist.

## Claims

1. Transmitter housing (4) of an operating device (2) for devices and systems, such as, in particular, remote-controlled mobile, industrial or commercial devices and systems,
having a housing wall (6) which encloses a receptacle (8), at least one operating element (12) being attached to an outer side (10) of the housing wall (6) and control electronics (22) being accommodated in the receptacle (8),
and having two holding elements (28, 34) which close the receptacle (8) and are connected to a left-side end (24) and a right-side end (30) of the housing wall (6), and which, on all sides (RI, Rr, Rv, Rb, Ro, Ru) of the housing wall (6), project beyond the contour (36) of said housing wall,
**characterized in that** the holding elements (28, 34) are produced from an elastomer material at least in a corresponding contact region (26, 32) with the housing wall (6) and can be sealingly biased against said housing wall.

2. Transmitter housing according to claim 1, **characterized in that** a circumferential outer contour (40) of each of the holding elements (28, 34) is additionally produced from the elastomer material.

3. Transmitter housing according to claim 1 or 2, **characterized in that** both holding elements (28, 34) have a main body (38) produced completely from the elastomer material.

4. Transmitter housing according to any of claims 1 to 3, **characterized in that** the holding elements (28, 34) each have two corner regions (42) at the bottom which are produced below the housing wall (6) from the elastomer material and which also extend beyond the extension of the housing wall (6) on the front side and rear side.

5. Transmitter housing according to any of claims 1 to 4, **characterized in that** the holding elements (28, 34) each have two corner regions (44) at the top which are produced above the housing wall (6) from the elastomer material and which also extend beyond the extension of the housing wall (6) on the front side and rear side.

6. Transmitter housing according to either one of 4 and 5, **characterized in that** the holding elements (28, 34) form at least one inner corner contour (46) on the corner regions (42) at the bottom and/or on the corner regions (44) at the top, said inner corner contour being shielded from the outside by a reversible bumper bracket (50), thus forming a free intermediate space (48).

7. Transmitter housing according to claim 6, **characterized in that** both holding elements (28, 34) form the inner corner contour (46) which is shielded from the outside by the reversible bumper bracket (50) on all four corner regions (42, 44), thus forming the free intermediate space (48).

8. Transmitter housing according to claim 6 or 7, **characterized in that** the bumper bracket (50) is curved at the relevant free intermediate space (48).

9. Transmitter housing according to any of claims 6 to 8, **characterized in that** the bumper bracket (50) and the associated free intermediate space (48) each extend from one side to at least one other side of the holding element.

10. Transmitter housing according to any of claims 6 to 9, **characterized in that** at least one of the bumper brackets (50) extends together with the associated free intermediate space (48) from a first side (SI) over an entire second side (S2) to a third side (S3) of the holding element (28; 34).

11. Transmitter housing according to claim 10, **characterized in that** a recessed grip (52) is formed on the second side (S2) in the associated free intermediate space (48).

12. Transmitter housing according to any of claims 6 to 11, **characterized in that** a protective bracket (54) is formed on one side of the holding elements (28, 34) between two of the bumper brackets (50), on which protective bracket an additional recessed grip (56) is formed.

13. Transmitter housing according to any of claims 6 to 12, **characterized in that** an antenna (58) is accommodated in at least one of the bumper brackets (50).

14. Transmitter housing according to any of claims 6 to 13,
**characterized in that** an additional receptacle (62) is embedded in at least one of the holding elements (28, 34), said receptacle being accessible via an end face (60) of the holding element (28, 34).

15. Transmitter housing according to claim 14, **characterized in that** a battery compartment (66) is inserted into the at least one additional receptacle (62).

16. Transmitter housing according to claim 14 or 15, **characterized in that** a bearing element (70) can be inserted into the additional receptacle (62), it being possible for said bearing element to be biased against the housing wall (6) with the holding element (28; 34) being positioned therebetween.

## Revendications

1. Boîtier d'émetteur (4) d'un appareil d'exploitation (2) pour des appareils et des systèmes, tels qu'en particulier pour des appareils et des systèmes mobiles, industriels ou commerciaux télécommandés
comportant une paroi de boîtier (6), qui entoure un logement (8), au moins un élément d'exploitation (12) étant disposé contre une face extérieure (10) de la paroi de boîtier (6) et une électronique de commande (22) étant logée dans le logement (8),
et comportant deux éléments de maintien (28, 34) fermant le logement (8), qui sont reliés à une extrémité gauche (24) et à une extrémité droite (30) de la paroi de boîtier (6) et qui ce faisant dépassent vers toutes les faces (RI, Rr, Rv, Rb, Ro, Ru) de la paroi de boîtier (6) au-dessus de son contour (36),
**caractérisé en ce que** les éléments de maintien (28, 34) sont fabriqués, au moins dans une zone de contact (26, 32) respective avec la paroi de boîtier (6) à partir du matériau élastomère et peuvent être serrés contre celle-ci de manière à s'autoétanchéifier.

2. Boîtier d'émetteur selon la revendication 1, **caractérisé en ce qu'**un contour externe (40) respectif périphérique des éléments de maintien (28, 34) est en plus fabriqué à partir du matériau élastomère.

3. Boîtier d'émetteur selon la revendication 1 ou 2, **caractérisé en ce que** les deux éléments de maintien (28, 34) présentent un corps de base (38) complètement fabriqué à partir du matériau élastomère.

4. Boîtier d'émetteur selon l'une des revendications 1 à 3,
**caractérisé en ce que** les éléments de maintien (28, 34) présentent respectivement deux zones d'angle (42), sur la face du fond, sous la paroi de boîtier (6), fabriquées à partir du matériau élastomère, qui s'étendent également sur la face avant et la face arrière au-delà de l'étendue de la paroi de boîtier (6).

5. Boîtier d'émetteur selon l'une des revendications 1 à 4,
**caractérisé en ce que** les éléments de maintien (28, 34) présentent respectivement deux zones d'angle (44), sur la face supérieure, au-dessus de la paroi de boîtier (6), fabriquées à partir du matériau élastomère, qui s'étendent également sur la face avant et sur la face arrière au-delà de l'étendue de la paroi de boîtier (6).

6. Boîtier d'émetteur selon l'une des revendications 4 ou 5,
**caractérisé en ce que** les éléments de maintien (28, 34) forment, au niveau des zones d'angle (42) sur la face du fond et/ou au niveau des zones d'angle (44) sur la face supérieure, au moins un contour d'angle (46) interne qui est protégé vers l'extérieur, tout en formant un espace intermédiaire (48) libre, par un étrier pare-chocs (50) réversible.

7. Boîtier d'émetteur selon la revendication 6, **caractérisé en ce que** les deux éléments de maintien (28, 34) forment le contour d'angle (46) interne protégé vers l'extérieur par l'étrier pare-chocs (50) réversible respectivement aux quatre zones d'angle (42, 44) avec formation de l'espace intermédiaire (48) libre.

8. Boîtier d'émetteur selon la revendication 6 ou 7, **caractérisé en ce que** l'étrier pare-chocs (50) est conçu sous forme d'arc au niveau de chaque espace intermédiaire (48) libre.

9. Boîtier d'émetteur selon l'une des revendications 6 à 8,
**caractérisé en ce que** l'étrier pare-chocs (50) et l'espace intermédiaire (48) libre associé s'étendent respectivement d'une face vers au moins une autre face de l'élément de maintien.

10. Boîtier d'émetteur selon l'une des revendications 6 à 9,
**caractérisé en ce qu'**au moins l'un des étriers pare-chocs (50) s'étend, conjointement avec l'espace intermédiaire (48) libre associé, à partir d'une première face (SI), sur la totalité d'une deuxième face (S2), jusqu'à une troisième face (S3) de l'élément de maintien (28, 34).

11. Boîtier d'émetteur selon la revendication 10, **caractérisé en ce qu'**une poignée de préhension (52) est conçue sur la deuxième face (S2), dans l'espace intermédiaire (48) libre associé.

12. Boîtier d'émetteur selon l'une des revendications 6 à 11,
**caractérisé en ce qu'**un étrier de protection (54), sur lequel une poignée de préhension supplémentaire (56) est formée, est conçu sur une face des éléments de maintien (28, 34) entre deux des étriers pare-chocs (50).

13. Boîtier d'émetteur selon l'une des revendications 6 à 12,
**caractérisé en ce qu'**une antenne (58) est logée dans au moins l'un des étriers pare-chocs (50).

14. Boîtier d'émetteur selon l'une des revendications 6 à 13,
**caractérisé en ce qu'**un logement supplémentaire (62), qui est accessible par l'intermédiaire d'une face frontale (60) de l'élément de maintien (28, 34) est réalisé dans au moins l'un des éléments de maintien (28, 34).

15. Boîtier d'émetteur selon la revendication 14, **caractérisé en ce qu'**un compartiment à batterie (66) est placé dans l'au moins un logement supplémentaire (62).

16. Boîtier d'émetteur selon la revendication 14 ou 15,
**caractérisé en ce qu'**un élément support (70) peut être placé dans le logement supplémentaire (62), lequel élément support peut être serré contre la paroi de boîtier (6) tout en interposant l'élément de retenue (28 ; 34).
